# DEMANDE DE BREVET EUROPEEN

(11) **EP 1 717 951 A1**
(43) Date de publication de la demande: **02.11.2006**
(21) Numéro de dépôt: 06290626.8
(22) Date de dépôt: 18.04.2006
(51) Int. Cl.: H03G 3/30, H03F 1/32

(54) **Contrôle de gain pour émetteur à boucle cartésienne avec des traitements numériques**

(30) Priorité: 22.04.2005 FR 0504078
(71) Demandeur: STMicroelectronics SA, 92120 Montrouge (FR)
(72) Inventeur: Tassin, Claire, 38000 Grenoble (FR); Garcia, Patrice, 38920 Crolles (FR)
(74) Mandataire: Cefai, Robin

(57) **Abrégé**

Ce dispositif (2) comprend un circuit (4) numérique adapté pour recevoir des signaux d'entrée (I, Q) ainsi que des signaux de contre-réaction cartésienne (I_{FB}, Q_{FB}). Il comprend un étage (20) de combinaison des signaux d'entrée (I, Q) et des signaux de contre-réaction (I_{FB}, Q_{FB}) pour générer des signaux d'erreur (I_{FW}, Q_{FW})

Ce circuit numérique est associé par l'intermédiaire d'un étage (8) de conversion à un circuit (6) analogique adapté pour recevoir les signaux d'erreur (I_{FW}, Q_{FW}), et qui comprend un étage (32) pour générer un signal de sortie à partir des signaux d'erreur (I_{FW}, Q_{FW}), et un étage (44) pour générer les signaux de contre-réaction (I_{FB}, Q_{FB}) à partir du signal de sortie.

II est caractérisé en ce que le circuit (4) numérique comprend en outre au moins un étage (10) de contrôle de gain disposé avant l'étage (20) de combinaison et adapté pour modifier le gain appliqué aux signaux d'entrée.

## Description

La présente invention concerne un dispositif et un procédé de contrôle de gain.
Des dispositifs de contrôle de gain à boucle cartésienne sont utilisés notamment dans des équipements mobiles de systèmes de radiocommunication dans lesquels le contrôle de gain doit être précis et avoir une dynamique importante.

Par exemple, dans un émetteur radio de type dit « Zero-IF » dans lequel des signaux en bande de base sont directement transposés à la fréquence d'émission sans passer par une ou des fréquences intermédiaires, le contrôle de gain est réparti sur plusieurs étages analogiques d'amplification de tension, ou VGA de l'anglais « Variable Gain Amplification », pour totaliser 75 dB de plage dynamique fonctionnelle par pas de 1 dB dans le cadre de la norme WCDMA de l'anglais « Wideband Code Division Multiple Access ».

Une telle architecture implique une importante consommation en courant et requiert une grande surface de silicium.

Par ailleurs, l'élévation des débits dans les télécommunications s'accompagne de modulations à enveloppe non-constante qui nécessitent des traitements linéaires. En conséquence, il est fait usage de dispositifs de linéarisation tels que, notamment, des dispositifs à boucle cartésienne qui sont généralement réalisés sous la forme de circuits analogiques. Cela nécessite un encombrement et une consommation incompatible avec les tendances actuelles d'intégration dans les équipements mobiles.

Récemment, des dispositifs de linéarisation à boucle cartésienne qui utilisent des composants numériques ont été décrits, notamment dans le document de brevet US 2004/0166813 A1.

De tels dispositifs connus comportent un circuit de traitement numérique qui est adapté pour recevoir des signaux d'entrée en bande de base ainsi que des signaux de contre-réaction cartésienne, et qui comprend un étage de combinaison des signaux d'entrée en bande de base et des signaux de contre-réaction pour générer des signaux d'erreur. Ce circuit de traitement numérique est associé par un étage de conversion analogique / numérique et numérique / analogique à un circuit de traitement analogique. Ce circuit de traitement analogique est adapté pour recevoir les signaux d'erreur et comprend un étage de sortie pour générer un signal de sortie à partir des signaux d'erreur ainsi qu'un étage de contre-réaction pour générer les signaux de contre-réaction à partir du signal de sortie.

Un tel dispositif peut être utilisé avec un contrôle de gain classique comportant plusieurs étages analogiques d'amplification, ce qui pose les problèmes de consommation et de surface évoqués précédemment. En particulier, ces problèmes de consommation et de surface vont à l'encontre des tendances qui visent à augmenter l'intégration en terme de surface pour réduire les coûts de fabrication en vue d'une utilisation dans un équipement mobile tel qu'un téléphone portable par exemple.

La présente invention vise à résoudre ce problème en définissant un dispositif et un procédé de contrôle de gain à boucle cartésienne permettant de réduire la consommation et l'encombrement.

A cet effet, la présente invention a pour objet un dispositif de contrôle de gain comprenant :
- un circuit de traitement numérique adapté pour recevoir des signaux d'entrée en bande de base ainsi que des signaux de contre-réaction cartésienne et comprenant un étage de combinaison des signaux d'entrée en bande de base et des signaux de contre-réaction cartésienne pour générer des signaux d'erreur ;
   associé par l'intermédiaire d'un étage de conversion analogique / numérique et numérique / analogique à :
- un circuit de traitement analogique adapté pour recevoir les signaux d'erreur, et comprenant un étage de traitement pour générer un signal de sortie à partir des signaux d'erreur, et un étage de contre-réaction pour générer les signaux de contre-réaction cartésienne à partir du signal de sortie ;
   caractérisé en ce que le circuit de traitement numérique comprend en outre au moins un étage de contrôle de gain disposé avant l'étage de combinaison et adapté pour modifier le gain appliqué aux signaux d'entrée en bande de base.

La présente invention a également pour objet un équipement mobile d'un système de radiocommunication comprenant un dispositif tel que décrit précédemment.

Enfin, l'invention concerne aussi un procédé de contrôle de gain comprenant :
- une étape de traitement en numérique de signaux d'entrée en bande de base comprenant une sous-étape de combinaison des signaux en bande de base et de signaux de contre-réaction cartésienne pour générer des signaux d'erreur ;
- une étape de traitement en analogique comprenant une sous-étape de génération d'un signal de sortie à partir des signaux d'erreur et une sous-étape de génération des signaux de contre-réaction cartésienne à partir du signal de sortie,
caractérisé en ce que l'étape de traitement en numérique comprend en outre une sous-étape de contrôle de gain en numérique, réalisée avant la sous-étape de combinaison, pour modifier le gain appliqué aux signaux d'entrée en bande de base.

Ainsi, grâce à l'utilisation d'un étage de contrôle de gain numérique, la dynamique de gain et la précision requise pour la réalisation de la boucle cartésienne peuvent être obtenus avec une faible consommation ainsi qu'une surface de silicium réduite.

D'autres avantages de l'invention apparaîtront dans les revendications dépendantes et à la lecture de la description et des dessins sur lesquels :
- la figure 1 est un schéma bloc d'un dispositif de contrôle de gain à boucle cartésienne selon l'invention ; et
- la figure 2 est un organigramme du procédé de contrôle de gain à boucle cartésienne de l'invention.

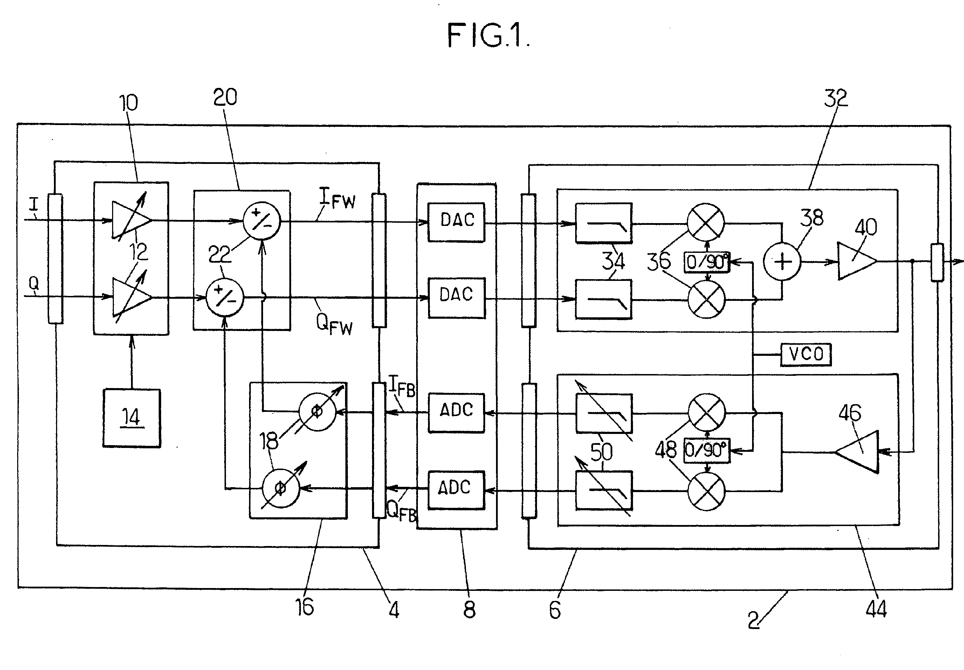

En référence à la figure 1, un mode de réalisation d'un dispositif de contrôle de gain pour un émetteur Zero-IF WCDMA à boucle cartésienne selon l'invention est désigné par la référence numérique générale 2. Il comprend un circuit 4 de traitement numérique associé à un circuit 6 de traitement analogique par un étage de convertisseurs 8 et comprend une boucle de contre-réaction cartésienne.

Le circuit 4 de traitement numérique est adapté pour recevoir des signaux d'entrée en bande de base, sous la forme, par exemple des composantes réelle I et imaginaire Q d'un signal d'entrée complexe.

Le circuit 4 de traitement numérique comporte également un étage 10 de contrôle de gain pour l'amplification et l'atténuation du gain des composantes I et Q des signaux en bande de base. Cet étage 10 comporte, sur chaque voie, un contrôleur numérique commandable 12, couramment désigné VGA et apte à amplifier et/ou atténuer le gain du signal d'entrée correspondant.

Les contrôleurs de l'étage 10 sont commandés par un étage de commande 14 adapté pour piloter le niveau de gain des différents contrôleurs de l'étage 10 en fonction des paramètres de fonctionnement du dispositif 2 et notamment en fonction des signaux en bande de base, des signaux de contre-réaction de la boucle cartésienne et des caractéristiques de composants des autres étages du dispositif et notamment de l'étage 8 de conversion. Cet étage 14 comprend la description du fonctionnement du dispositif 2 sous la forme d'un algorithme de commande.

L'étage 10 de contrôle de gain étant réalisé à l'aide de circuits numériques, il est commandé directement par l'étage 14 de commande, ce qui permet une meilleure intégration et une diminution de la surface de silicium nécessaire.

Dans le mode de réalisation décrit, l'étage 10 de contrôle de gain est adapté pour assurer une variation de 66 dB de dynamique de gain.

Le circuit 4 de traitement numérique est également adapté pour recevoir les signaux de contre-réaction cartésienne issu de la boucle de contre-réaction cartésienne c'est-à-dire, une composante, notée I_{FB}, correspondant au signal de contre-réaction de la partie réelle et une composante, noté Q_{FB}, correspondant au signal de contre-réaction de la partie imaginaire. L'indice FB est utilisé pour le terme anglais « FeedBack ».

Les signaux de contre-réaction cartésienne sont tout d'abord introduits dans un étage 16 de correction de phase comprenant de manière classique un déphaseur 18 sur chaque voie.

Les sorties de l'étage 10 d'amplification et 16 de correction de phase sont introduites dans un étage 20 de combinaison des signaux en bande de base et des signaux de contre-réaction cartésienne, adapté pour générer des signaux d'erreur.

De manière classique, cet étage 20 de combinaison réalise une comparaison des signaux en bande de base et des signaux de contre-réaction. A cet effet, il comprend des soustracteurs 22 adaptés pour déterminer la différence entre chaque composante en bande de base après amplification et chaque composante de contre-réaction cartésienne après correction de phase.

Ainsi, l'étage 20 de combinaison génère des signaux d'erreur correspondant à deux composantes notées I_{FW} et Q_{FW}. L'indice FW est utilisé pour le terme anglais « Forward ».

Ces signaux d'erreur correspondent aux signaux en bande de base diminués des signaux de contre-réaction. En conséquence, ils comprennent les non linéarités des signaux en bande de base de la chaîne directe de la boucle. Ces signaux d'erreur servent pour la création des signaux de contre-réaction comme indiqué plus loin, de sorte que la soustraction des signaux de contre-réaction apporte la prédistorsion nécessaire aux signaux pour linéariser le spectre en sortie.

Le circuit 4 de traitement numérique est associé au circuit 6 de traitement analogique par l'intermédiaire de l'étage 8 de conversion comprenant :
- des convertisseurs numériques / analogiques, notés DAC de l'anglais « Digital to Analog Converter », convertissant les signaux du circuit 4 de traitement numérique vers le circuit 6 de traitement analogique ; et
- des convertisseurs analogiques / numériques, notés ADC de l'anglais « Analog to Digital Converter », convertissant les signaux du circuit 6 de traitement analogique vers le circuit 4 de traitement numérique.

Dans le mode de réalisation décrit, les convertisseurs numériques / analogiques DAC sont des convertisseurs 14 bits et les convertisseurs analogiques / numériques ADC sont réalisés de manière classique.

Le circuit 6 de traitement analogique est adapté pour recevoir les signaux d'erreur tels que délivrés par l'étage de conversion 8 dans un étage de traitement 32 comprenant, dans l'exemple décrit, des filtres anti-repliement référencés 34, suivis de mélangeurs 36, en quadrature, et d'un additionneur 38 additionnant les deux voies pour générer un signal, dit signal utile RF, à un amplificateur 40. L'amplificateur 40 génère un signal de sortie du circuit 6 de traitement analogique.

Le signal de sortie est également introduit dans un étage de contre-réaction 44.

Cet étage 44 comporte tout d'abord un atténuateur 46 relié à deux mélangeurs en quadrature 48, qui démodulent le signal de sortie en deux signaux bande de base en quadrature I_{FB} et Q_{FB} chacun formant une composante de contre-réaction cartésienne.

Avantageusement, un même contrôleur VCO, de l'anglais « Voltage Control Oscillator » est utilisé pour générer les signaux d'oscillateur local des mélangeurs 36 de l'étage de traitement 32 et les signaux d'oscillateur local des mélangeurs 48 de l'étage de contre-réaction 44.

Chacune de ces composantes est introduite dans un filtre commandable 50 présentant une dynamique de gain de 9 dB. Ces filtres 50 sont reliés en sortie aux convertisseurs analogiques / numériques ADC de l'étage de conversion 8 pour générer les composantes I_{FB} et Q_{FB} de contre-réaction cartésienne.

Avantageusement, la commande du gain des filtres 50 est également assurée par l'étage de commande 14.

Dans le mode de réalisation décrit, la plage dynamique fonctionnelle de chaque étage 10 et 50 de contrôle de gain est déterminée en fonction de la résolution des convertisseurs numériques / analogiques DAC. En effet, le dimensionnement des DAC limite la dynamique de gain de l'étage 10 de contrôle de gain du circuit 4 de traitement numérique pour éviter toute perte d'informations au niveau des DAC résultant d'une atténuation trop importante des signaux qui empêcherait un codage précis des puissances les plus faibles.

Dans l'exemple décrit, les DAC sont réalisés dans une technologie telle que la technologie CMOS 0.13 µm et fonctionnent à une fréquence de l'ordre de 38 MHz soit dix fois la largeur du canal selon la norme WCDMA, afin de relâcher les contraintes sur le dimensionnement des filtres 34 placés en sortie des DAC.

Il est toutefois nécessaire de réserver une partie de la dynamique des DAC pour coder le plancher de bruit de quantification afin de pouvoir coder un signal de faible puissance.

Le DAC 14 bits est segmenté en 11 bits dédiés à une plage de 66 dB et un plancher de quantification de 3 bits. Avec une plage dynamique de 1,2 V, on obtient un codage en binaire des pas d'atténuation de 1 dB et un bit de moindre poids ou LSB de 13 µV avec une précision de 0.2 dB.

La plage dynamique fonctionnelle totale de contrôle de gain de 75 dB est séparée en une première fraction de 66 dB assurée par les contrôleurs 12 de l'étage de contrôle 10 du circuit numérique 4, et une seconde fraction de 9 dB assurée par les filtres 50 de l'étage de contre-réaction du circuit analogique 6.

En conséquence, pour une atténuation de 0 à 66 dB, on utilise uniquement les VGA numériques 12 de l'étage de contrôle 10 et pour des atténuations de 67 à 75 dB, on utilise simultanément les VGA numériques 12 de l'étage de contrôle 10 et le gain supplémentaire de 9 dB des filtres de boucle 50, chaque étage de contrôle de gain étant adapté pour assurer le contrôle de gain sur une fraction respective de la plage dynamique fonctionnelle de 75 dB.

La performance des mélangeurs 36 influe également sur la plage de contrôle de gain assurée par l'étage 10. En effet, les mélangeurs introduisent une fuite d'oscillateur local et une atténuation trop forte des signaux utiles aboutit à la dégradation du rapport signal à bruit. En conséquence, la fraction de la plage dynamique fonctionnelle dans laquelle le gain est contrôlé par l'étage 10 de contrôle de gain du circuit 4 de traitement numérique est déterminée en fonction de ladite performance des composants formant les étages dans lesquels transite le signal utile et notamment les étage 8 de conversion et 32 de traitement.

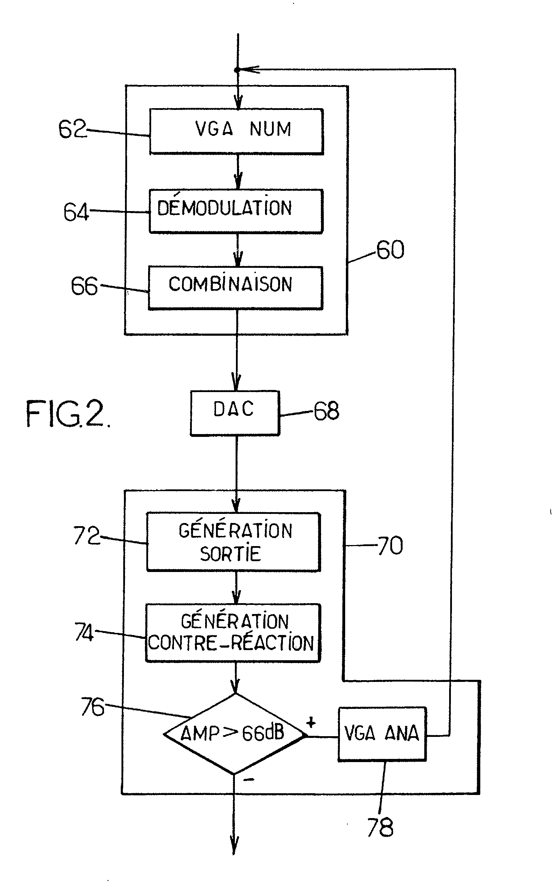

Le dispositif décrit en référence à la figure 1 permet de mettre en oeuvre le procédé représenté par l'organigramme de la figure 2.

Ce procédé débute par la fourniture des signaux en bande de base en vue de leur émission radio fréquence.

Le procédé comporte ensuite une étape de traitement en numérique 60 qui comprend une sous-étape 62 de contrôle de gain numérique, mise en oeuvre par l'étage 10 de contrôle de gain, pour modifier le gain des signaux d'entrée en bande de base sur la fraction de plage dynamique de 0 à 66 dB comme indiqué précédemment.

L'étape 60 comprend également une sous-étape 64 de démodulation des signaux de contre-réaction qui est suivie d'une sous-étape 66 de combinaison des signaux en bande de base amplifiés avec les signaux de contre-réaction cartésienne transposés pour générer les signaux d'erreur.

Ces signaux d'erreur sont convertis en deux signaux analogiques lors d'une étape de conversion 68 mise en oeuvre par les DAC de l'étage de conversion 8, suivie d'une étape 70 de traitement en analogique comprenant une sous-étape 72 de génération d'un signal de sortie à partir des signaux d'erreur par modulation radio-fréquence puis amplification. Le procédé comprend ensuite une sous-étape 74 de génération des signaux de contre-réaction cartésienne à partir du signal de sortie par prélèvement de la sortie radio-fréquence et démodulation.

Avantageusement, l'étape 70 comprend également un test 76 pour déterminer si la dynamique de gain excède 66 dB. Si ce test est positif, alors le contrôle de gain réalisé lors de la sous-étape 62 n'est pas suffisant et le procédé comprend une sous-étape 78 de contrôle du gain analogique des signaux de contre-réaction mise en oeuvre par les filtres à gain variable 50. Dans le mode de réalisation décrit, cela consiste à activer une modification de gain de 9 dB sur les filtres de boucle 50. Le procédé retourne ensuite à l'étape 60 et pour continuer avec la sous-étape 62 qui est à nouveau réalisée. Ce rebouclage permet de conserver la précision requise sur les pas de 1dB à l'issue du contrôle de gain mis en oeuvre par les filtres 50.

Cette sous-étape 78 ainsi que le rebouclage sont réalisés uniquement pour assurer le contrôle de gain sur la fraction de plage dynamique entre 66 et 75 dB.

Bien entendu, d'autres modes de réalisation de l'invention peuvent être envisagés.

Notamment, dans une première variante, les DAC de l'étage de conversion 8 sont dimensionnés de sorte que l'étage de contrôle 10 du circuit numérique 4 mis en oeuvre lors de la sous-étape 62 assure le contrôle de gain sur l'ensemble de la plage dynamique fonctionnelle.

Avantageusement, dans un tel mode de réalisation, les DAC sont à 17 bits et les filtres 50 ne sont pas à gain variable, de sorte que le circuit analogique 6 correspond à un circuit classique et que la sous-étape 78 n'est pas réalisée.

En outre, le contrôle de gain dans le circuit 6 de traitement analogique peut être réalisé par d'autres composants que les filtres 50 et éventuellement par des composants dédiés.

Par ailleurs, d'autres étages peuvent être introduits dans le dispositif tels que, par exemple, un étage de compensation de la composante continue, placé à l'entrée du circuit 4 de traitement numérique.

De même, l'amplificateur 40 peut comporter un étage de préamplification PPA et un étage d'amplification PA et les signaux utilisés, pour former les signaux de contre-réaction cartésienne, peuvent être prélevés à la sortie de n'importe lequel de ces étages d'amplification.

Avantageusement, les VGA numériques 12 de l'étage de contrôle 10 sont implémentés, comme cela est décrit dans le document de brevet US 2004/0184569 A1, en calculant les atténuations en base logarithmique et non en base linéaire, de manière à éviter l'utilisation de multiplieurs complexes pour utiliser des additionneurs moins encombrants dans l'étage de combinaison.

Dans l'exemple décrit, l'invention est prévue pour une utilisation dans un environnement mobile utilisant la norme WCDMA mais l'invention peut également être appliquée dans tout type d'environnement et, notamment, avec d'autre plages dynamiques fonctionnelles, dans des stations de base ou encore avec d'autres normes, telle que la norme CDMA2000.

## Revendications

1. Dispositif (2) de contrôle de gain comprenant :
- un circuit (4) de traitement numérique adapté pour recevoir des signaux d'entrée en bande de base (I, Q) ainsi que des signaux de contre-réaction cartésienne (I_{FB}, Q_{FB}) et comprenant un étage (20) de combinaison des signaux d'entrée en bande de base (I, Q) et des signaux de contre-réaction cartésienne (I_{FB}, Q_{FB}) pour générer des signaux d'erreur (I_{FW}, Q_{FW}) ;
associé par l'intermédiaire d'un étage (8) de conversion analogique / numérique et numérique / analogique à :
- un circuit (6) de traitement analogique adapté pour recevoir les signaux d'erreur (I_{FW}, Q_{FW}), et comprenant un étage (32) de traitement pour générer un signal de sortie à partir des signaux d'erreur (I_{FW}, Q_{FW}), et un étage (44) de contre-réaction pour générer les signaux de contre-réaction cartésienne (I_{FB}, Q_{FB}) à partir du signal de sortie ;
**caractérisé en ce que** le circuit (4) de traitement numérique comprend en outre au moins un étage (10) de contrôle de gain disposé avant l'étage (20) de combinaison et adapté pour modifier le gain appliqué aux signaux d'entrée en bande de base.

2. Dispositif selon la revendication 1, **caractérisé en ce que** l'étage (10) de contrôle de gain du circuit (4) de traitement numérique est adapté pour assurer le contrôle de gain sur l'ensemble d'une plage dynamique fonctionnelle.

3. Dispositif selon la revendication 2, **caractérisé en ce que** l'étage (8) de conversion comprend des convertisseurs numériques / analogiques (DAC) 17 bits reliant le circuit (4) de traitement numérique au circuit (6) de traitement analogique, l'étage (10) de contrôle de gain du circuit (4) de traitement numérique étant adapté pour assurer le contrôle de gain dans une plage de l'ordre de 75 dB.

4. Dispositif selon la revendication 1, **caractérisé en ce que** le circuit (6) de traitement analogique comprend un étage (50) de contrôle de gain appliqué aux signaux de contre-réaction cartésienne (I_{FB}, Q_{FB}), chacun des étages de contrôle de gain (10, 50) respectivement du circuit (4) de traitement numérique et du circuit (6) de traitement analogique étant adapté pour assurer le contrôle de gain sur une fraction respective d'une plage dynamique fonctionnelle.

5. Dispositif selon la revendication 4, **caractérisé en ce qu'**il comprend des étages (8, 32) formés de composants aux performances prédéterminées et au travers desquels les signaux transitent, la fraction de la plage dynamique fonctionnelle dans laquelle le gain est contrôlé par l'étage (10) de contrôle de gain du circuit (4) de traitement numérique étant déterminée en fonction des performances de ces composants.

6. Dispositif selon la revendication 4, **caractérisé en ce que** l'étage (8) de conversion comprend des convertisseurs numériques / analogiques (DAC) reliant le circuit (4) de traitement numérique au circuit (6) de traitement analogique, qui sont des convertisseurs 14 bits, l'étage (10) de contrôle de gain du circuit (4) de traitement numérique étant adapté pour assurer le contrôle de gain dans une plage de l'ordre de 66 dB et l'étage (50) de contrôle de gain du circuit (6) de traitement analogique étant adapté pour assurer le contrôle de gain dans une plage de l'ordre de 9 dB.

7. Equipement mobile d'un système de télécommunication, **caractérisé en ce qu'**il comprend un dispositif selon l'une quelconque des revendications 1 à 6.

8. Procédé de contrôle de gain comprenant :
- une étape (60) de traitement en numérique de signaux d'entrée en bande de base (I, Q) comprenant une sous-étape (66) de combinaison des signaux en bande de base et des signaux de contre-réaction cartésienne (I_{FB}, Q_{FB}) pour générer des signaux d'erreur (I_{FW}, Q_{FW}) ;
- une étape (70) de traitement en analogique comprenant une sous-étape (72) de génération d'un signal de sortie à partir des signaux d'erreur (I_{FW}, Q_{FW}) et une sous-étape (74) de génération des signaux de contre-réaction cartésienne (I_{FB}, Q_{FB}) à partir du signal de sortie,
**caractérisé en ce que** l'étape de traitement en numérique (60) comprend en outre une sous-étape (62) de contrôle de gain en numérique, réalisée avant la sous-étape de combinaison (66), pour modifier le gain appliqué aux signaux d'entrée en bande de base.

9. Procédé selon la revendication 8, **caractérisé en ce que** la sous-étape (62) de contrôle de gain en numérique est adaptée pour assurer le contrôle de gain sur l'ensemble d'une plage dynamique fonctionnelle.

10. Procédé selon la revendication 8, **caractérisé en ce que** l'étape (70) de traitement en analogique comprend une sous-étape (78) de contrôle de gain en analogique, chacune des sous-étapes (62) de contrôle de gain en numérique et (78) de contrôle de gain en analogique étant adaptée pour assurer le contrôle de gain sur une fraction respective d'une plage dynamique fonctionnelle.
